(19) Europäisches Patentamt
European Patent Office
Office européen des brevets

(11) Veröffentlichungsnummer: **0 223 114**
**B1**

# (12) EUROPÄISCHE PATENTSCHRIFT

(45) Veröffentlichungstag der Patentschrift: **08.08.90**

(51) Int. Cl.[5]: **G03F 7/004**

(21) Anmeldenummer: **86114916.9**

(22) Anmeldetag: **27.10.86**

(54) **Durch Photopolymerisation vernetzbare Gemische.**

(30) Priorität: **19.11.85 DE 3540950**

(43) Veröffentlichungstag der Anmeldung: **27.05.87 Patentblatt 87/22**

(45) Bekanntmachung des Hinweises auf die Patenterteilung: **08.08.90 Patentblatt 90/32**

(84) Benannte Vertragsstaaten: **AT CH DE ES FR GB IT LI NL SE**

(56) Entgegenhaltungen:
**EP-A- 0 115 190**
**EP-A- 0 130 804**
**DE-A- 2 136 076**
**DE-A- 2 309 613**
**DE-A- 2 359 626**
**GB-A- 835 849**
**GB-A- 1 386 794**
**GB-A- 2 046 285**
**US-A- 2 893 868**

(73) Patentinhaber: **BASF Aktiengesellschaft, Carl-Bosch-Strasse 38, D-6700 Ludwigshafen(DE)**

(72) Erfinder: **Koch, Horst, Dr., Schliffgasse 22, D-6711 Grosskarlbach(DE)**
Erfinder: **Ziegler, Walter, Dr., Starenweg 15, D-6803 Edingen-Neckarhausen(DE)**

**EP 0 223 114 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft durch Photopolymerisation vernetzbare Gemische auf der Grundlage von Bindemitteln, hiermit verträglichen photopolymerisierbaren Monomeren und Photoinititatoren, die als Bindemittel Copolymerisate auf der Basis von Ethylen, (Meth)Acrylsäure und mindestens einem weiteren Comonomeren enthalten und die sich für die Herstellung von photovernetzbaren Druckplatten, Reliefplatten und Photoresists sowie von photovernetzten Druckformen, Reliefformen und Photoresists eignen. Außerdem betrifft die Erfindung photovernetzte Druckplatten, Reliefplatten und Photoresists sowie Druckformen, Reliefformen und Photoresists mit verbesserten Eigenschaften, hergestellt unter Verwendung der Gemische.

Gemische dieser Art sind allgemein bekannt und vielfach beschrieben. Sie weisen jedoch häufig Nachteile, wie beispielsweise eine zu geringe Flexibilität, Elastizität, Lagerfähigkeit oder Chemikalienstabilität, eine zu hohe Ozonempfindlichkeit, Thermolabilität oder Quellbarkeit in Druckfarbenlösungsmitteln oder eine zu schlechte Löslichkeit oder Dispergierbarkeit in flüssigen polaren Medien, auf. Dies erschwert oder verhindert oftmals ihre Verwendung zur Herstellung von photovernetzten Hoch- oder Flachdruckformen, Reliefformen oder von Photoresists.

Ebenso sind Gemische, die Ethylen-Copolymerisate enthalten, bekannt.

So beschreibt US-PS 4 010 128 Flexodruckformen, welche aus beispielsweise Ethylen-Ethylacrylat-Copolymerisaten und Styrol-1,3-Butadien-Styrol-Blockcopolymerisaten bestehen. Es handelt sich dabei aber nicht um photovernetzbare Gemische; das druckende Relief muß in diese Schichten durch Einpressen einer konventionellen Druckform-Matrix eingebracht werden.

DE-OS 25 48 451 beschreibt ein Verfahren zur Herstellung von Hochdruckformen, die aus einem Fasermaterial bestehen. Dabei wird auf einer Faserlage aus Kunstfasern ein Oberflächenfilm aus beispielsweise Ethylen-Vinylacetat-, Ethylen-Acrylsäure- oder Ethylen-Acrylsäureester-Copolymerisaten aufgebracht, in den man das Druckmuster mit Hilfe einer Matrize einpreßt. Auch hierbei handelt es sich nicht um photovernetzbare Gemische.

Diese Gemische und die daraus hergestellten Formen können demnach auch nicht die bei der Verwendung üblicher photovernetzbarer Gemische auftretenden Probleme lösen.

DE-OS 27 18 047 beschreibt ein wasserentwickelbares photovernetzbares Gemisch, welches ein wasserlösliches Methacrylsäurepolymer enthält. Letzteres kann auch Ethylen enthalten, allerdings nur bis zu einer Menge von 30 %, vorzugsweise bis zu 15 %, angegeben als Verhältnis der sich wiederholenden Einheiten in der Polymerkette, da ansonsten die Wasserlöslichkeit verloren geht. Diese Gemische werden vor allem zur Herstellung von Offset-Druckformen verwendet. Für andere Verwendungszwecke sind die aus diesen photovernetzbaren Gemischen hergestellten photovernetzten Formen zu hart und zu spröde.

Ethylen-Copolymerisate, die außer Ethylen noch mindestens zwei weitere Comonomere aufweisen, sind ebenfalls bekannt und werden für die unterschiedlichsten Zwecke angewendet. So beschreibt GB-PS 1 386 794 die Verwendung eines Ethylen-Copolymerisats, welches 2 bis 40 Gew.% Methacrylsäure und 5 bis 48 Gew.% eines Vinylesters, Alkylacrylats oder Alkylmethacrylats aufweist, zur Herstellung von Stahllaminaten. DE-OS 2 359 626 beschreibt einen Copolymerisat-Latex zur Herstellung von Klebstoffen, wobei das Copolymerisat im wesentlichen 5 bis 25 Gew.% Ethylen, 0,1 bis 10 Gew.% (Meth)acrylsäure, 60 bis 90 Gew.% eines Vinylesters und 0,1 bis 10 Gew.% eines Hydroxialkylacrylates enthält. DE-OS 21 36 076 empfiehlt Copolymerisate aus 50 bis 93 Gew.% Ethylen, 2 bis 40 Gew.% Methacrylsäure und 5 bis 48 Gew.% eines Gemischs aus einem Vinylester und einem Alkyl(meth)acrylat zum Verbinden einer Silikatglasplatte mit einer Kunststoffplatte. EP-PS 115 190 beschreibt Ionomere aus beispielsweise 10 bis 87 Gew.% Ethylen, 3 bis 30 Gew.% Acrylsäure und 10 bis 60 Gew.% eines Alkylacrylats oder eines Vinylethers, deren Carboxylgruppen zu 3 bis 90 % neutralisiert sind, und ihre Verwendung als Überzüge für Golfbälle. Die Verwendung derartiger Ethylen-Copolymerisate in durch Photopolymerisation vernetzbaren Gemischen ist nicht bekannt.

Der vorliegenden Erfindung lag die Aufgabe zugrunde, neue, durch Photopolymerisation vernetzbare Gemische für die Herstellung von photovernetzbaren Druckplatten, Reliefplatten und Photoresists sowie von photovernetzten Druckformen, Reliefformen und Photoresists zu finden, die im unbelichteten Zustand eine gute Löslichkeit bzw. Dispergierbarkeit in flüssigen polaren Medien und eine hohe Lagerfähigkeit sowie in belichteten Zustand eine gute Löslichkeitsdifferenzierung zwischen belichteten und unbelichteten Anteilen, eine hohe Flexibilität, Elastizität, Chemikalien- und Thermostabilität, Abriebfestigkeit und Dimensionsstabilität, eine geringe Quellbarkeit in Druckfarbenlösungsmitteln und vor allem eine sehr geringe Ozonempfindlichkeit aufweisen. Der Erfindung lag außerdem die Aufgabe zugrunde, verbesserte photovernetzbare Druckplatten, Reliefplatten und Photoresists sowie verbesserte photovernetzte Druckformen, Reliefformen und Photoresists zu finden.

Demgemäß wurden durch Photopolymerisation vernetzbare Gemische auf der Grundlage von Bindemitteln, hiermit verträglichen photopolymerisierbaren Monomeren und Photoinitiatoren gefunden, die als Bindemittel Copolymerisate, hergestellt aus

$a_1$) 30 bis 70, insbesondere 40 bis 60 Gew.% Ethylen,
$a_2$) 5 bis 40, insbesondere 8 bis 30 Gew.% (Meth)Acrylsäure und

$a_3$) 5 bis 50, insbesondere 20 bis 40 Gew.% mindestens eines Vinylesters, Vinylethers, (Meth)Acrylsäureesters und/oder (Meth)Acrylsäureamids,

enthalten.

Außerdem wurde gefunden, daß sich diese Gemische hervorragend für die Herstellung von photovernetzbaren Druckplatten, Reliefplatten und Photoresists sowie von photovernetzten Druckformen, Reliefformen und Photoresists eignen. Desweiteren wurden photovernetzbare Druckplatten, Reliefplatten und Photoresists sowie photovernetzte Druckformen, Reliefformen und Photoresists hoher Kautschukelastizität und Ozonstabilität gefunden, welche unter Verwendung dieser Gemische hergestellt wurden.

Die genannten Platten, Formen und Photoresists werden im folgenden der Kürze halber als "lichtempfindliche Aufzeichnungsmaterialien" bezeichnet.

Der Begriff "flüssige polare Medien" bezeichnet im Rahmen der vorliegenden Erfindung Lösungsmittel, Lösungsmittelgemische oder Gemische aus Lösungsmitteln und Zusatzstoffen, die ein hohes Dipolmoment und/oder ionische Ladungen aufweisen und daher in der Lage sind, mit sich selbst oder mit anderen Verbindungen Dipol-Dipol-, Dipol-Ion- oder Ion-Ion-Wechselwirkungen einzugehen. Er bezeichnet auch solche Lösungsmittel, Lösungsmittelgemische oder Gemische aus Lösungsmitteln und Zusatzstoffen, die die vorstehend genannten Eigenschaften aufweisen und zudem locker gebundene Protonen oder Hydroxylionen besitzen.

Im Hinblick auf den genannten Stand der Technik war es überraschend und für den Fachmann nicht vorhersehbar, daß mit Hilfe der erfindungsgemäß anzuwendenden Copolymerisate durch Photopolymerisation vernetzbare Gemische hergestellt werden können, die kautschukelastisch, trotz ihres hohen Ethylengehaltes in flüssigen polaren Medien löslich oder zumindest leicht dispergierbar und außerdem noch ozonstabil sind und die sich daher sehr gut für die Herstellung von lichtempfindlichen Aufzeichnungsmaterialien eignen. Diese wiederum weisen überraschende Vorteile auf. So sind sie im unbelichteten Zustand lagerfähig, dimensionsstabil und nicht klebrig. Nach der bildmäßigen Belichtung mit aktinischem Licht zeigen sie eine hervorragende Löslichkeitsdifferenzierung zwischen ihren belichteten und unbelichteten Anteilen, so daß sie in einfacher Weise mit Hilfe flüssiger polarer, insbesondere aber wäßriger Medien, entwickelbar sind. Die entwickelten lichtempfindlichen Aufzeichnungsmaterialien sind zudem so flexibel, daß sie mehrfach auf kleine Druckzylinder aufgespannt werden können. Sie quellen auch kaum unter der Einwirkung wäßriger Druckfarben; sie sind dimensionsstabil und abriebfest und darüber hinaus ozonstabil. So erlauben sie auch bei hohen Druckauflagen eine sehr gute, auch in den feinsten Elementen exakte und vorlagentreue Bildreproduktion. Die erfindungsgemäßen Aufzeichnungsmaterialien zeigen auch noch andere wesentliche und wichtige anwendungstechnische Vorteile gegenüber den aus dem Stand der Technik bekannten, wie z.B. bessere Zwischentiefen in gerasterten Halbtonflächen und Negativlinien.

Die als Bindemittel verwendeten Copolymerisate aus $a_1$ Ethylen, $a_2$ (Meth)Acrylsäure und $a_3$ mindestens einem Vinylester, Vinylether, (Meth)Acrylsäureester und/oder (Meth)Acrylsäureamid sind an sich bekannt. Ihre Darstellung erfolgt nach der LDPE (= low density polyethylene) -Hochdruckpolymerisationsmethode bei Temperaturen von 200 bis 400°C und einem Druck von mehr als 800 kg/cm$^2$ [siehe z.B. DE-PS 23 41 462, US-PS 3 264 272].

Als Comonomere $a_3$ geeignete Vinylester sind insbesondere solche der allgemeinen Struktur (I),

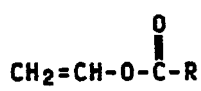

(I)

worin R einen Alkyl- oder Cycloalkylrest mit 1 bis 10 C-Atomen bedeutet, z.B. Vinylacetat, Vinylpropionat, Vinylbutyrat, Valeriansäurevinylester oder Hexancarbonsäurevinylester. Bevorzugt ist Vinylacetat.

Als Comonomere $a_3$ geeignete Vinylether sind insbesondere solche der Struktur (II),

$$CH_2 = CH - OR \qquad (II)$$

z.B. Vinylethylether, Vinyl-1-propylether, Vinyl-1-butylether, Vinyl-2-butylether oder Vinyl-1-pentylether. Bevorzugt ist Vinyl-1-butylether.

Als Comonomere $a_3$ geeignete (Meth)Acrylsäureester und -amide sind insbesondere solche der Struktur (III)

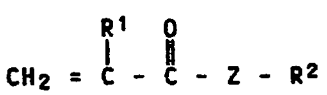

(III)

worin $R^1$ ein Wasserstoffatom oder eine Methylgruppe, Z ein Sauerstoffatom oder eine $NR^3$-Gruppe - mit $R^3$ = H oder $C_1$-$C_4$-Alkyl und $R^2$ einen Alkyl- oder Cycloalkylrest mit 1 bis 10 C-Atomen oder einen ω-

Alkyl-poly(alkylenoxid)-α-oxyl-Rest bedeutet. Geeignete (Meth)Acrylsäureester und -amide sind z.B. Methylacrylat, Methylmethacrylat, Ethylacrylat, Ethylmethacrylat, Propylacrylat, Propylmethacrylat, n-Butylacrylat, n-Butylmethacrylat, n-Pentylacrylat, n-Pentylmethacrylat, n-Hexylacrylat, n-Hexylmethacrylat, tert.-Butylacrylat, Cyclohexylacrylat, Cyclohexylmethacrylat, 2-Ethylhexylacrylat, 2-Ethylhexylmethacrylat, Dicyclopentadienylacrylat, ω-Methyl-poly(ethylenoxid)-α-yl-(meth)acrylat, ω-Methyl-poly(propylen-1,2-oxid)-α-yl-(meth)acrylat, ω-Methyl-poly(propylen-1,3-oxid)-α-yl-(meth)acrylat, N-Ethylacrylamid, N-Methyl-N-butylmethacrylamid oder N-Ethyl-N-(2-ethylhexyl)-acrylamid. Bevorzugt sind n-Butylacrylat, 2-Ethylhexylacrylat, ω-Methyl-poly(ethylenoxid)-α-yl-acrylat und Dicyclopentadienylacrylat, von denen die ersten drei besonders bevorzugt sind.

Bevorzugte Bindemittel sind demnach Ethylen-(Meth)Acrylsäure-Copolymerisate, welche n-Butylacrylat, 2-Ethylhexylacrylat und/oder ω-Methyl-poly(ethylenoxid)-α-yl-acrylat als Comonomere $a_3$ einpolymerisiert enthalten und eine Shore-A-Härte von mehr als 10, insbesondere 15 bis 75 besitzen. Die erfindungsgemäß anzuwendenden Copolymerisate werden in einer Menge von 30 bis 99,5, vorteilhafterweise 40 bis 96, bevorzugt 50 bis 93 und insbesondere 60 bis 90 Gew.%, bezogen auf ein erfindungsgemäßes Gemisch, verwendet.

Geeignete photopolymerisierbare Monomere sind nicht gasförmig und müssen über eine durch freie Radikale angeregte Kettenfortpflanzungsreaktion und Additionspolymerisation ein Hochpolymeres bilden können und außerdem mit den erfindungsgemäßen Bindemittel verträglich sein. Unter "verträglich" ist hier die Fähigkeit von zwei oder mehreren Bestandteilen zu verstehen, ineinander dispergiert zu bleiben.

Eine Klasse von geeigneten photopolymerisierbaren Monomeren bilden die ungesättigten Ester von Alkoholen, insbesondere Ester von α-Methylencarbonsäuren und substituierten α-Methylencarbonsäuren, insbesondere Ester dieser Art von Alkylenpolyolen und Polyalkylenpolyolen, wobei Alkylenpolyoldi- und -triacrylate und Polyalkylenpolyoldi- und -triacrylate, die aus Alkylenpolyolen mit 2 bis 15 Kohlenstoffatomen oder Polyalkylenetherpolyolen oder -glykolen mit 1 bis 10 Etherbindungen hergestellt worden sind, besonders bevorzugt werden.

Die folgenden speziellen Verbindungen veranschaulichen weitere geeignete Monomere: Ethylenglykoldiacrylat, Diethylenglykoldiacrylat, Glycerindiacrylat, Glycerintriacrylat, Trimethylolpropantriacrylat, Ethylenglykoldimethacrylat, 1,3-Propandioldimethacrylat, 1,2,4-Butantrioltrimethacrylat, 1,4-Cyclohexandioldiacrylat, 1,4-Benzoldioldimethacrylat, 1,2-Benzoldimethanoldiacrylat, Pentaerythrittriacrylat, Pentaerythrittetramethacrylat, 1,3-Propandioldiacrylat, 1,3-Pentandioldimethacrylat, p-α,α-Dimethylbenzylphenylacrylat, tert.-Butylacrylat, N,N-Diethylaminoethylacrylat, N,N-Diethylaminoethylmethacrylat, 1,4-Butandioldiacrylat, 1,6-Hexandioldiacrylat, 1,6-Hexandioldimethacrylat, 1,10-Decandioldiacrylat, 2,2-Dimethylolpropandiacrylat, Tripropylenglykoldiacrylat, 2,2-Di(p-hydroxiphenyl)propandiacrylat, 2,2-Di-(p-hydroxiphenyl)propandimethacrylat, Polyoxiethyl-2,2-di(p-hydroxiphenyl)propandimethacrylat, Polyoxipropyltrimethylolpropantriacrylat (Molekulargewicht 462), 1,4-Butandioldimethacrylat, 1,6-Hexandiolmethacrylat, 2,2,4-Trimethyl-1,3-pentandioldimethacrylat, 1-Phenylethylen-1,2-diol-dimethacrylat, Trimethylolpropandi(meth)acrylat, Triethylenglykoldiacrylat, Tetramethylenglykoldiacrylat, Ethylenglykolacrylatphthalat, Polyoxiethyltrimethylolpropantriacrylat, Diacrylat- und Dimethacrylatester von Diepoxipolyethern, die von aromatischen Polyhydroxyverbindungen, beispielsweise Bisphenolen, Novolaken und ähnlichen Verbindungen abgeleitet sind, wie beispielsweise die in der US-PS 3 661 576 beschriebenen Verbindungen, die Bisacrylate und -methacrylate von Polyethylenglykolen vom Molekulargewicht von 200 bis 500 und dgl. Es können aber auch Alkylpolyalkylenoxidmono(meth)acrylate, wie z.B. ω-Methyl-poly(ethylenoxid)-α-yl-acrylat, verwendet werden. Ferner kommen auch Umsetzungsprodukte von Glycerin, Epichlorhydrin und Acrylsäure im Molverhältnis von z.B. 1:3:3 in Frage.

Eine weitere Klasse von geeigneten Monomeren bilden die in der US-PS 2 927 022 beschriebenen Verbindungen, beispielsweise Verbindungen mit mehreren polyadditionspolymerisierbaren olefinischen Bindungen, besonders wenn sie als endständige Bindungen vorhanden sind, insbesondere Verbindungen, in denen wenigstens eine und vorzugsweise die meisten dieser Bindungen mit einem doppelt gebundenen Kohlenstoffatom einschließlich Kohlenstoff, der an Kohlenstoff und Heteroatome wie Stickstoff, Sauerstoff und Schwefel doppelt gebunden ist, konjugiert sind. Bevorzugt werden Verbindungen, in denen die ethylenisch ungesättigten Gruppen, insbesondere die Vinylidengruppen, mit Ester- oder Amidstrukturen konjugiert sind. Spezielle Beispiele solcher Verbindungen sind die ungesättigten Amide, insbesondere solche mit α-Methylencarbonsäuren, ω-Diaminen und ω-Diaminen, die durch Sauerstoff unterbrochen sind, z.B. Methylen-bis-acrylamid, Methylen-bis-methacrylamid, Ethylen-bis-methacrylamid, 1,6-Hexamethylen-bis-acrylamid, Diethylentriamin-tris-methacrylamid, Bis-(γ-methacrylamidopropoxi)-ethan, β-Methacrylamidoethyl-methacrylat, N-(β-Methacryloxiethyl)-acrylamid, Vinylester, z.B. Divinylsuccinat, Divinyladipat, Divinylphthalat, Divinylterephthalat, Divinylbenzol-1,3-disulfonat und Divinylbutan-1,4-disulfonat und Diallylfumarat.

Als weitere geeignete Monomere seien genannt: Styrol und Styrol-Derivate, 1,4-Diisopropenylbenzol, 1,3,5-Triisopropenylbenzol, Addukte von Itaconsäureanhydrid mit Hydroxiethylacrylat (1:1), mit flüssigen Butadien-Acrylnitril-Polymerisaten, die endständige Aminogruppen enthalten, und Addukte von Itaconsäureanhydrid mit Diacrylaten und Dimethacrylaten von Diepoxipolyethern, die in der US-PS 3 661 576 beschrieben werden, Polybutadien und Butadien-Acrylnitril-Copolymerisate mit endständigen und seitenständigen Vinylgruppen und ungesättigte Aldehyde, z.B. Sorbaldehyd (2,4-Hexadienal).

Geeignete Monomere, die wasserlöslich sind oder Carboxylgruppen oder andere mit Alkali reaktionsfähige Gruppen enthalten, sind besonders gut geeignet, wenn das Material mit wäßrigen Medien entwickelbar sein soll. Außerdem können die in den US-Patentschriften US-PS 3 043 805 und 2 929 710 genannten polymerisierbaren, olefinisch ungesättigten Polymerisate und ähnliche Materialien allein oder in Mischung mit anderen Materialien verwendet werden. Acrylsäure- und Methacrylsäureester von Addukten von Ethylenoxid und Polyhydroxiverbindungen, wie sie in der US-PS 3 380 831 beschrieben werden, sind ebenfalls geeignet.

Bei Verwendung von Carboxylgruppen enthaltenden Monomeren können die Carboxylgruppen teilweise oder vollständig mit Metallhydroxiden, -carbonaten u.a. oder mit anorganischen und organischen Stickstoffbasen wie Ammoniak oder Triethylamin neutralisiert werden.

Im allgemeinen werden die geeigneten photopolymerisierbaren Monomeren in einer Menge von 1 bis 40, insbesondere 5 bis 30 Gew.%, bezogen auf ein erfindungsgemäßes Gemisch, verwendet.

Bevorzugt sind Trimethylolpropantriacrylat, 1,6-Hexandioldiacrylat, 1,6-Hexandioldimethacrylat, ω-Methyl-poly(ethylenoxid)-α-yl-acrylat und Tetraethylenglykoldiacrylat.

Geeignete Photoinitiatoren, die allein oder in Mischung miteinander eingesetzt werden sollen, sind beispielsweise Acyloine und deren Derivate, wie Benzoin, Benzoinalkylether, z.B. Benzoinisopropylether, α-Methylolbenzoin und dessen Ether, wie z.B. α-Methylolbenzoinmethylether, oder α-Methylbenzoin und α-Methylbenzoinethylether; vicinale Diketone und deren Derivate, wie z.B. Benzil, Benzilacetale, wie Benzildimethylacetal, Benzilmethylethylacetal, Benzilmethylbenzylacetal oder Benzilethylenglykolacetal; sowie insbesondere Acylphosphinoxid-Verbindungen des Typs, wie sie z.B. in der DE-A-29 09 992 und der DE-A-31 14 341 für die Verwendung in photopolymerisierbare Mischungen beschrieben sind. Bevorzugte Vertreter von Initiatoren aus der Klasse der Acylphosphinoxide sind 2,6-Dimethoxibenzoyldiphenylphosphinoxid, 2,4,6-Trimethylbenzoyldiphenylphosphinoxid, 2,4,6-Trimethylbenzoylphenylphosphinsäureethylester und 2,4,6-Trimethylbenzoylphenylphosphinsäure-Natrium-Salz. Die Photoinitiatoren können auch in Verbindung mit anderen Coinitiatoren und/oder Aktivatoren, wie sie in der einschlägigen Literatur beschrieben sind, verwendet werden. Es kommen aber auch photoreaktive Initiatoren, welche eine kationische Polymerisation initiieren wie Pyrryliumhexafluorarsenate gemäß EP-PS 74 073 in Frage. Bevorzugt sind Benzildimethylacetal und/oder 2,4,6-Trimethylbenzoyldiphenylphosphinoxid.

Im allgemeinen werden geeignete Photoinitiatoren in einer Menge von 0,001 bis 10, vorzugsweise 0,1 bis 8 und insbesondere 0,1 bis 3 Gew.%, bezogen ein erfindungsgemäßes Gemisch, verwendet.

Die erfindungsgemäßen Gemische können ferner geeignete nicht photopolymerisierbare oder photovernetzbare Hilfs- und/oder Zusatzstoffe enthalten. Dazu gehören z.B. Inhibitoren der thermisch initiierten Polymerisation, Verarbeitungshilfsmittel und Weichmacher, Farbstoffe und Pigmente sowie Salzbildner, d.h. Kationen liefernde Substanzen.

Geeignete Inhibitoren der thermisch initiierten Polymerisation sind z.B. Hydrochinon, Hydrochinon-Derivate, 2,6-Di-tert.-butyl-p-kresol, Nitrophenole, N-Nitrosamine, wie N-Nitrosodiphenylamin oder die Salze, insbesondere die Alkali-, Calcium- und Aluminiumsalze, des N-Nitrosocyclohexylhydroxylamins. Bevorzugt sind 2,6-Di-tert.-butyl-p-kresol und die Alkalisalze des N-Nitrosocyclohexylhydroxylamins. Im allgemeinen werden sie in einer Menge von 0,001 bis 5 Gew.%, bezogen auf ein erfindungsgemäßes Gemisch, verwendet.

Als Verarbeitungshilfsmittel und Weichmacher kommen z.B. Dialkylphthalate, Alkylphosphate, Sulfonamide, Polyethylenglykol, Polyethylenglykolester und -ether in Frage. Ferner können Amphiphile auf der Basis von Polyethylenglykol/ Fettsäuren oder Polyethylenglykol-Polypropylenoxid-Blockcopolymerisaten verwendet werden. Im allgemeinen werden sie in einer Menge von 1 bis 20 Gew.%, bezogen auf ein erfindungsgemäßes Gemisch, verwendet.

Von den Farbstoffen haben die löslichen Phenazinium-, Phenoxazinium-, Acridinium- und Phenothiazinium-Farbstoffe besondere Bedeutung, wie z.B. Neutralrot (C.I. 50 040), Safranin T (C.I. 50 240), Rhodanilblau, dem Salz bzw. Amid aus Rhodamin D (Basic Violett 10, C.I. 45 170), Methylenblau (C.I. 52 015), Thionin (C.I. 52 025) und Acridinorange (C.I. 46 005); oder auch Sudantiefschwarz X 60 (C.I. 26 150). Diese Farbstoffe, die im allgemeinen in Mengen von 0,0001 bis 2 Gew.%, bezogen auf ein erfindungsgemäßes Gemisch, zugesetzt werden können, werden vorteilhaft zusammen mit einer hinreichenden Menge eines Reduktionsmittels verwendet, welches den Farbstoff in Abwesenheit von aktinischem Licht nicht reduziert, bei Belichtung den Farbstoff im angeregten Elektronenzustand jedoch reduzieren kann. Beispiele solcher milden Reduktionsmittel sind Ascorbinsäure, Anethol, Thioharnstoff und seine Derivate wie Diethylallylthioharnstoff und insbesondere N-Allylthioharnstoff sowie Hydroxylaminderivate, vorzugsweise Salze des N-Nitrosocyclohexylhydroxylamins, insbesondere die Kalium-, Calcium- und Aluminiumsalze. Letztere können auch als Inhibitoren der thermisch initiierten Polymerisation verwendet werden. Die Menge der zugesetzten Reduktionsmittel kann im allgemeinen etwa 0,005 bis 5 Gew.%, insbesondere 0,01 bis 1 Gew.%, bezogen auf ein erfindungsgemäßes Gemisch, betragen, wobei sich in vielen Fällen der Zusatz des 3- bis 10-fachen der Menge an mitverwendetem Farbstoff bewährt hat.

Geeignete Salzbildner sind

1. anorganische Metallverbindungen wie Oxide, Hydroxide, Alkoxide mit 1 bis 4 C-Atomen im Alkylrest oder Carbonate der Kationen von Li, Mg, Ca, Sr, Ba, Al, Ga, In, Ge, Sn, Pb, Sb, Bi, Zn, Cd, Mg, Cn, Sc, Y, La, Ti, Zr, Hf, V, Nb, Ta, Cr, Mo, W, Mn, Re, Fe, Co, Ni, Pd oder den Lanthaniden oder
2. organische Metallverbindungen der Struktur (IV)

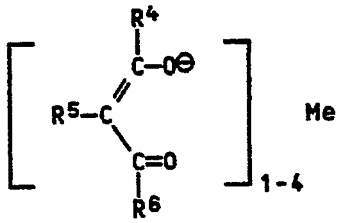

(IV),

worin Me ein Kation eines der vorstehend genannten Elemente bedeutet, $R^4$, $R^5$ und $R^6$ gleichartige oder verschiedenartige Alkyl-, Cycloalkyl-, Aryl- oder Alkylarylgruppen darstellen, wobei die Reste $R^4$ und $R^6$ cyclisch über Ringsysteme miteinander verknüpft sein können und wobei ferner $R^5$ auch noch ein Wasserstoffatom kennzeichnen kann, oder
3. mehrfachfunktionelle Amine wie Ethylendiamin, Diethylentriamin, N-Methyl-N-ethyl-ethylendiamin, N,N-Dimethyl-ethylendiamin, N,N'-Diethylethylendiamin, N,N,N',N'-Tetramethylethylendiamin, N,N,N",N"-Tetramethylethylentriamin, 1,3-Diaminopropan, 1,4-Diaminobutan, Pyrazin oder Polyvinylpyridin oder
4. Hydrazin.

Bevorzugt sind die Oxide, Hydroxide, Alkoxide, Carbonate und Acetylacetonate von $Li^{\oplus}$, $Mg^{2\oplus}$, $Ca^{2\oplus}$, $Sr^{2\oplus}$, $Ba^{2\oplus}$, $Al^{3\oplus}$, $Sn^{2\oplus}$, $Sb^{3\oplus}$ und $Zn^{2\oplus}$, wobei Bis(acetylacetonato)-Zn(II), MgO und LiOH besonders bevorzugt sind.

Sie können in einer Menge von 0,05 bis 20, vorzugsweise 0,5 bis 15 und insbesondere 1 bis 10 Gew.%, bezogen auf ein erfindungsgemäß anzuwendendes Copolymerisat, verwendet werden.

Weitere Hilfs- und Zusatzstoffe sind Mittel zur Verbesserung der Reliefstruktur, wie beispielsweise 9,9'-Dianthronyl und 10,10'-Bisanthron gemäß DE-OS 27 20 560.

Alle genannten Komponenten der durch Photopolymerisation vernetzbaren Gemische bzw. der lichtempfindlichen Aufzeichnungsmaterialien sind dabei so aufeinander abgestimmt, daß die lichtempfindlichen Aufzeichnungsmaterialien nach der bildmäßigen Belichtung mit aktinischem Licht mit flüssigen polaren Medien auswaschbar, d.h. entwickelbar sind. In Frage kommende flüssige polare Medien sind z.B. Diethylether, Di-n-butylether, Ethylbutylether, Tetrahydrofuran, Dioxan, Aceton, Methylethylketon, Methylbutylketon, Acetonitril, Propionitril, Acetylaceton, Acetylessigsäureethylester, Pyridin, Pyrrol, Pyrazin, Chloroform, Wasser, Methanol, Ethanol, Propanol, n-Butanol, Ethanolamin, Diethanolamin, Triethanolamin, Essigsäure oder Propionsäure sowie Gemische aus diesen, sofern sie miteinander mischbar sind. Sie können auch Zusatzstoffe, wie z.B. Ammoniak, Amine, Metallhydroxide, organische und anorganische Säuren, organische und anorganische Salze sowie organische Verbindungen enthalten. Bevorzugt sind eine 0,5 %ige Alkalihydroxidlösung in Wasser, Wasser mit 0,5 Gew.% an Alkalihydroxid und 0,01 Gew.% an Paraffinsulfonatnatriumsalz mit 12 bis 18 Kohlenstoffen in der Kohlenwasserstoffkette sowie ein Gemisch aus Tetrachlorethylen und n-Butanol im Volumenverhältnis von 4:1.

Die Herstellung der erfindungsgemäßen, durch Photopolymerisation vernetzbaren Gemische aus den genannten Komponenten weist keine methodischen Besonderheiten auf, sondern kann in geeigneter Weise durch Knet-, Misch-und Lösungstechniken erfolgen.

Die erfindungsgemäßen Gemische können dann für die Herstellung von lichtempfindlichen Aufzeichnungsmaterialien in geeigneter Weise, beispielsweie durch Gießen aus einer Lösung, Heißpressen, Kalandrieren oder Extrudieren zu Flächengebilden unterschiedlichster Dicke geformt werden. Diese Flächengebilde werden entweder als solche oder im Verbund mit anderen schichtförmigen Materialien als lichtempfindliche Aufzeichnungsmaterialien verwendet werden. Im folgenden werden die Flächengebilde als "reliefbildende Schicht (RS)" bezeichnet. Aufzeichnungsmaterialien, die eine reliefbildende Schicht (RS) im Verbund mit anderen schichtförmigen Materialien aufweisen, werden im folgenden "Mehrschichtenelemente" genannt.

Die Dicke der reliefbildenden Schicht (RS) kann, je nach Anwendungszweck der lichtempfindlichen Aufzeichnungsmaterialien, in weiten Grenzen schwanken und wird im allgemeinen im Bereich von 0,1 bis 6000 µm liegen. Für die Herstellung von Hochdruckformen, Reliefformen und Photoresists sind Schichtdicken im Bereich von 20 bis 6500 µm, für die Herstellung von Flachdruckformen solche von 1 bis 200 µm bevorzugt.

In solchen Mehrschichtenelementen kommen als Träger (T) die für die Herstellung von Druckformen, Reliefformen oder Photoresistmustern üblichen und bekannten, dimensionsstabilen, starren oder flexiblen Träger in Betracht. Hierzu gehören insbesondere dimensionsstabile Kunststoff-Folien, wie z.B. Polyesterfolien, gummielastische Folien oder Schaumstoffe sowie metallische Träger, z.B. Stahl-, Eisen-, Nickel- oder Aluminiumbleche oder konische Nickelröhren (sleeves). Für die Herstellung von Photoresistschichten können auch Kupfer, kupferbeschichtete Materialien, gedruckte Schaltungen etc. als Trägermaterialien für die reliefbildenden Schichten (RS) Anwendung finden. Die Träger (T), insbesondere die metallischen, können in an sich bekannter Art mechanisch, chemisch, elektrochemisch und/oder durch Versehen mit einer Haftgrundierung vorbehandelt sein. Zur Erzielung einer hinreichenden Haftfestigkeit zwischen Träger (T) und reliefbildender Schicht (RS) können, insbesondere bei Mehrschichtenelementen für die Herstellung von Druck-und Reliefformen, zwischen dem Träger (T) und der reliefbildenden Schicht (RS) eine oder mehrere, im allgemeinen 0,4 bis 40 µm dicke, Haftschichten angeordnet sein. Die Wahl des Trägermaterials richtet sich vornehmlich nach dem vorgesehenen Anwendungszweck der Mehrschichtenelemente. Für die Haftschicht zwischen Träger (T) und reliefbildender Schicht (RS) kommen beispielsweise bekannte 1- oder 2-Komponentenkleber auf Polyurethanbasis oder Haftschichten gemäß DE-OS 30 15 419 in Betracht.

Auf die reliefbildende Schicht (RS) der Mehrschichtenelemente kann noch mindestens eine gegebenenfalls mattierte Deckschicht und/oder Schutzschicht aufgebracht werden, die beispielsweise aus Polyvinylalkohol mit einem hohen Verseifungsgrad oder aus Mischungen von Polyvinylalkohol mit den erfindungsgemäß anzuwendenden Copolymerisaten besteht. Es kommen aber auch Schutz- und/oder Deckfolien aus Polystyrol, Polyethylen, Polypropylen oder Polyethylenterephthalat in Frage, die sich nach oder vor der bildmäßigen Belichtung mit aktinischem Licht von der reliefbildenden Schicht (RS) abziehen lassen. Eine Schutz- und/oder Deckschicht und eine entsprechende abziehbare Folie können zusammen verwendet werden, dabei liegt die Deck- und/oder Schutzschicht der reliefbildenden Schicht (RS) direkt auf und bleibt mit ihr beim Abziehen der Folie haftfest verbunden. Zwischen der Deck- und/oder Schutzschicht und der entsprechenden Folie kann sich noch eine Antihaftschicht gemäß EP-PS 68 599 befinden. Die Deck-und/oder Schutzschichten bzw. -folien sowie der Träger (T) können Lichthofschutzmittel wie Flexogelb enthalten.

Die lichtempfindlichen Aufzeichnungsmaterialien bzw. Mehrschichtenelemente eignen sich beispielsweise für die Herstellung von Flachdruckformen oder von Photoresists, wie sie z.B. bei der Herstellung von gedruckten Schaltungen, integrierten Schaltkreisen, in der Halbleitertechnik, in der Ätzformtechnik etc. Verwendung finden, sowie zur Herstellung von Reliefstrukturen. Vor allem aber eignen sie sich für die Herstellung von Flexodruckformen und Hochdruckformen, bei letzteren auch für den Azkidenzbereich. Hierzu wird die reliefbildende Schicht (RS) der lichtempfindlichen Aufzeichnungsmaterialien bzw. der Mehrschichtenelemente in üblicher und an sich bekannter Weise bildmäßig mit aktinischem Licht belichtet und durch Auswaschen der unbelichteten, unvernetzten Schichtanteile mit flüssigen polaren Medien entwickelt.

Für die Belichtung, die in Form einer Flach- oder Rundbelichtung erfolgen kann, eignen sich die üblichen Lichtquellen von aktinischem Licht, wie beispielsweise UV-Fluoreszenz-Röhren, Quecksilberhoch-, -mittel- oder -niederdruckstrahler, superaktinische Leuchtstoffröhren, Xenon-Impulslampen, Metallhalogenid-dotierte Lampen, Kohlebogenlampen etc. Die emittierte Wellenlänge soll im allgemeinen zwischen 230 und 450 nm, bevorzugt zwischen 300 und 420 nm liegen und auf die Eigenabsorption des mitverwendeten Photoinitiators abgestimmt sein.

Das Entwickeln des Reliefbildes kann durch Waschen, Bürsten etc. mit dem polaren Entwicklerlösungsmittel erfolgen. Wegen der großen Wasserbeständigkeit der belichteten reliefbildenden Schicht (RS) besitzen die Aufzeichnungsmaterialien bzw. Mehrschichtenelemente den Vorteil, daß die Auswaschbedingungen bei der Entwicklung verschärft werden können, ohne daß dies zu einer Beeinträchtigung der Druckformen, Reliefformen oder Photoresistmuster führt. Im Gegenteil lassen sich hierdurch schärfere Reliefstrukturen erhalten. Nach dem Auswaschen werden die resultierenden Druckformen, Reliefformen oder Photoresistmuster in üblicher Weise, gegebenenfalls bei Temperaturen bis zu 120°C getrocknet. In manchen Fällen ist es zweckmäßig, die erhaltenen Druckformen, Reliefformen oder Photoresistmuster anschließend nochmals vollflächig mit aktinischem Licht nachzubelichten, um die Festigkeit der Reliefschicht zu erhöhen.

Diese lichtempfindlichen Aufzeichnungsmaterialien, welche unter Verwendung der erfindungsgemäßen Gemische hergestellt werden, ergeben nicht nur Druckformen, Reliefformen und Photoresistmuster mit einer außerordentlich hohen Wasserbeständigkeit, so daß sie auch in einem feucht-warmen Klima eine hohe Lagerbeständigkeit und hohe Wiederverwendbarkeit besitzen, sondern auch Produkte mit besseren Zwischentiefen und besserer Schärfe als die herkömmlichen Systeme, ausgeprägter Reliefstruktur sowie hoher Elastizität und glatter Oberfläche.

Die Erfindung wird durch die nachfolgenden Beispiele erläutert. Die in den Beispielen genannten Teile und Prozente beziehen sich, soweit nicht anders angegeben, auf das Gewicht. Volumenteile verhalten sich zu Teilen wie Liter zu Kilogramm.

Für die erfindungsgemäßen Beispiele wurde eine Reihe von Copolymerisaten nach der Lehre der DE-PS 23 41 462, US-PS 3 264 272 hergestellt. Ihre Zusammensetzung zeigt Tabelle 1, wichtige, für die Anwendung relevante Eigenschaften zeigt Tabelle 2.

Die Shore-A-Härte wurde gemäß DIN 53 505 bestimmt. Der "melt flow index" MFI wurde bei 160°C mit einer Auflagekraft von 325 p oder bei 190°C mit einer Auflagekraft von 2,16 kp gemessen. Die Ozonstabilität der Aufzeichnungsmaterialien wurde bei 25°C bei einer Ozonkonzentration von 50 ppm an 10 cm langen Proben, die einer 10 %igen Längendehnung unterworfen waren, bestimmt; Kriterium war, ob innerhalb von 10 Stunden Risse auftraten. Die Gewichtsquellung in % wurde nach 24stündiger Lagerung in Wasser bei 25°C ermittelt.

Tabelle 1: Zusammensetzung der Copolymerisate

| Copolymerisat/ Monomere | Gehalt an einpolymerisierten Monomeren (%) 1 | 2 | 3 | 4 | 5 |
|---|---|---|---|---|---|
| Ethylen | 53,8 | 43,9 | 57,1 | 51,6 | 52 |
| Acrylsäure | 9,2 | 19,2 | 18,9 | 14,4 | 17 |
| n-Butylacrylat | 37 | 37 | 24 | - | 19 |
| ω-Methyl-poly-(ethylenoxid)-α-yl-acrylat | - | - | - | 24 | 12 |
| 2-Ethylhexylacrylat | - | - | - | 10 | - |

Tabelle 2: Eigenschaften der Copolymerisate

| Copolymerisat/ Eigenschaft | 1 | 2 | 3 | 4 | 5 |
|---|---|---|---|---|---|
| MFI* | $200^2$ | $15^1$ | $48^2$ | $28^1$ | $15^1$ |
| Shore A-Härte | 21 | 14 | 40 | 35 | 22 |

* MFI = melt flow index;
1 = 160°C/325 p;
2 = 190°C/2,16 kp;

Herstellung von durch Photopolymerisation vernetzbaren Gemischen und von lichtempfindlichen Aufzeichnungsmaterialien bzw. Mehrschichtenelementen

Beispiel 1

Ein Gemisch wurde aus den nachstehend genannten Komponenten hergestellt:
76,494 % Copolymerisat 2 gemäß Tabelle 1,
10 % Trimethylolpropantriacrylat,
10 % Tetraethylenglykoldiacrylat,
3 % Benzildimethylacetal,
0,5 % 2,6-Di-tert.-butyl-p-kresol und
0,006 % Sudantiefschwarz X 60 (C.I. 26150).

Die Komponenten wurden in einem Lösungsmittelgemisch aus Toluol und Methylethylketon im Volumenverhältnis von 1:1 gelöst, und die Endkonzentration der Lösung wurde mit dem Lösungsmittelgemisch auf 28 %, bezogen auf das Gesamtgewicht der Lösung, eingestellt. Die Lösung wurde auf eine 125 µm dicke Polyethylenterephthalat-Folie gegossen, so daß eine Trockenschichtdicke von 1000 µm resultierte. Nach dem Aufkaschieren einer 9 µm dicken Polyesterfolie wurde dieses Mehrschichtenelement 25 Minuten lang durch eine Negativvorlage belichtet. Anschließend wurde die 9 µm dicke Polyesterfolie entfernt und die belichtete Schicht 20 Minuten lang in 0,5 %iger wäßriger Natronlauge mit einem Bürstenwascher entwickelt. Nach der Trocknung wurde ein Reliefbild mit einer Relieftiefe von 700 µm erhalten, das den transparenten Bereichen des Negativs entsprach. Die Gewichtsquellung nach 24stündiger Lagerung in Wasser bei 20°C betrug nur 0,6 %. Die weichelastische Platte hatte eine klebfreie Oberfläche und zeichnete sich durch eine gute Bildauflösung aus. Selbst nach einer längeren Lagerungszeit waren

keine Ozonrisse auf der Oberfläche festzustellen. Die weichelastische Platte, ließ sich ohne weiteres mehrmals auf kleine Druckzylinder aufspannen und lieferte auch nach mehrmaligem Gebrauch sehr gute Druckergebnisse.

Beispiel 2

Ein Gemisch und ein Mehrschichtenelement wurde wie in Beispiel 1 aus
86,5 % Copolymerisat 3 gemäß Tabelle 1,
6,3 % 1,6-Hexandioldiacrylat,
3,7 % 1,6-Hexandioldimethacrylat,
3 % Benzildimethylacetal und
0,5 % 2,6-Di-tert.-butyl-p-kresol
hergestellt. Das Mehrschichtenelement wurde 20 Minuten lang durch eine Negativvorlage belichtet und 30 Minuten lang bei 40°C in 0,5 %iger wäßriger Kalilauge mit einem Bürstenwascher entwickelt. Nach der Trocknung erhielt man Klischees mit einer Shore A-Härte von 63 und einer Relieftiefe von 700 µm, die ausgezeichnete anwendungstechnische Eigenschaften aufwiesen.

Beispiel 3

Ein Gemisch wurde aus:
85 % Copolymerisat 4 gemäß Tabelle 1,
10 % Trimethylolpropantriacrylat,
3 % Benzildimethylacetal und
2 % 2,6-Di-tert.-butyl-p-kresol
durch 20 minütiges Kneten bei 120°C in einem Plastographen hergestellt. Hierbei wurde zunächst das Bindemittel plastifiziert und anschließend eine Mischung aus Monomer, Initiator und Inhibitor zugesetzt. Man erhielt eine transparente, klebrige Masse, die zwischen einer Stahlunterlage und einer Polyesterfolie in einer Heißpresse bei 120°C zu einer Schichtdicke von 1250 µm verpreßt wurde. Nach dem Abkühlen wurde dieses Mehrschichtenelement 10 Minuten lang bildmäßig belichtet, die Polyesterfolie entfernt und mit einem Bürstenwascher in 0,5 %iger wäßriger Natronlauge, welche 0,01 % an Paraffinsulfonatnatriumsalz enthielt, entwickelt. Nach dem Trocknen erhielt man eine Reliefschicht mit einer Relieftiefe von 800 µm und einer Härte von 61 Shore A.

Beispiel 4

Ein Gemisch wurde durch Extrusion von
82,994 % Copolymerisat 5 gemäß Tabelle 1, stabilisiert mit 2,6-Di-tert.-butyl-p-kresol,
10 % ω-Methyl-poly(ethylenoxid)-α-yl-acrylat,
5,0 % Trimethylolpropantriacrylat,
2,0 % Benzildimethylacetal und
0,006 % Sudantiefschwarz X 60 (C.I. 26150)
in einem Zweischneckenextruder hergestellt. Dabei wurde das Copolymerisat 5 wurde über eine Förderschnecke gleichmäßig in den Extruder eingetragen und bei 140°C aufgeschmolzen. Die übrigen Komponenten wurden nacheinander in den Extruder eingepumpt und die Mischung aus einer Breitschlitzdüse ausgetragen. Mit einer Kalanderwalze wurde eine 3000 µm dicke reliefbildende Schicht zwischen einer 125 µm dicken Polyesterfolie und einem 3 µm dicken Substrat aus Polyvinylalkohol hergestellt. Dieses Mehrschichtenelement wurde während 3 Minuten durch die Polyesterfolie vorbelichtet und anschließend während 20 Minuten durch eine auf das Polyvinylalkohol-Substrat aufgelegte Negativvorlage hindurch belichtet. Nach Entfernen der Negativvorlage wurde das Aufzeichnungsmaterial geteilt und a) mit 0,5 %iger wäßriger Natronlauge bei 50°C in einem Bürstenwascher und b) mit Tetrachlorethylen-n-Butanol (Volumenverhältnis 4:1) in einem Sprühwascher entwickelt. Nach beiden Entwicklungsprozessen erhielt man Klischees mit einer Relieftiefe von 1000 µm und einer Shore A-Härte von 48 bis 50. Ihre Gewichtsquellung in Wasser war kleiner als 5 %. Beide Klischees waren ozonbeständig und konnten mehrfach auf kleine Druckzylinder aufgespannt werden, ohne dabei zu zerbrechen.

Beispiel 5

Ein Gemisch wurde gemäß Beispiel 1 aus
88 % Copolymerisat 1 gemäß Tabelle 1,
6,7 % 1,6-Hexandioldiacrylat,
3,3 % 1,6-Hexandioldimethacrylat und
2 % Benzildimethylacetal
hergestellt.

Die Lösung wurde auf ein 300 µm, dickes Stahlblech gegossen, so daß eine Trockenschichtdicke von 1600 µm resultierte. Nach dem Aufkaschieren einer 9 µm dicken Polyesterfolie wurde dieses Mehrschichtenelement 15 Minuten lang durch eine Negativvorlage hindurch belichtet. Anschließend wurde die Folie entfernt und 6 Minuten lang mit einer Mischung aus Tetrachlorethylen-n-Butanol (Volumenverhältnis 4:1) entwickelt. Nach der Trocknung erhielt man ein Klischee mit guter Bildauflösung, einer Relieftiefe von 600 µm und einer Härte von 44 Shore A.

**Patentansprüche für die Vertragsstaaten: CH, DE, ES, FR, GB, IT, LI, NL, SE**

1. Durch Photopolymerisation vernetzbare Gemische auf der Grundlage von Bindemitteln, hiermit verträglichen photopolymerisierbaren Monomeren und Photoinitiatoren, dadurch gekennzeichnet, daß sie als Bindemittel Copolymerisate, hergestellt aus
$a_1$) 30 bis 70 Gew.% Ethylen,
$a_2$) 5 bis 40 Gew.% (Meth)Acrylsäure und
$a_3$) 5 bis 50 Gew.% mindestens eines Vinylesters, Vinylethers, (Meth)Acrylsäureesters und/oder (Meth)Acrylsäureamids,
enthalten.

2. Gemische gemäß Anspruch 1, dadurch gekennzeichnet, daß sie als Bindemittel Copolymerisate, hergestellt aus
$a_1$) 40 bis 60 Gew.% Ethylen,
$a_2$) 8 bis 30 Gew.% (Meth)Acrylsäure und
$a_3$) 20 bis 40 Gew.% mindestens eines Vinylesters, Vinylethers, (Meth)Acrylsäureesters und/oder (Meth)Acrylsäureamids,
enthalten.

3. Gemische gemäß Anspruch 1 oder 2, dadurch gekennzeichnet, daß die Copolymerisate als Baustein $a_3$ n-Butylacrylat, 2-Ethylhexylacrylat und/oder ω-Methyl-poly(ethylenoxid)-α-yl-acrylat einpolymerisiert enthalten.

4. Gemische gemäß einem der Ansprüche 1, 2 oder 3, dadurch gekennzeichnet, daß die Copolymerisate als Salze von Kationen von Metallen, mehrfach funktionellen Aminen und/oder von Hydrazin vorliegen.

5. Verwendung der Gemische gemäß einem der Ansprüche 1, 2 oder 3 für die Herstellung von photovernetzbaren Druckplatten, Reliefplatten und Photoresists.

6. Verwendung der Gemische gemäß einem der Ansprüche 1, 2 oder 3 für die Herstellung von photovernetzten Druckformen, Reliefformen und Photoresists.

7. Photovernetzbare Druckplatten, Reliefplatten und Photoresists, hergestellt unter Verwendung von Gemischen gemäß einem der Ansprüche 1, 2 oder 3.

8. Photovernetzte Druckformen, Reliefformen und Photoresists, hergestellt unter Verwendung von Gemischen gemäß einem der Ansprüche 1, 2 oder 3.

**Patentansprüche für den Vertragsstaat : AT**

1. Verfahren zur Herstellung photovernetzter Druckformen, Reliefformen und Photoresists durch bildmäßiges Belichten und Auswaschen der unbelichteten Schichtanteile von photovernetzbaren Druckplatten, Reliefplatten und Photoresists mit reliefbildenden Schichten (RS) aus durch Photopolymerisation vernetzbaren Gemischen auf der Grundlage von Bindemitteln, hiermit verträglichen photopolymerisierbaren Monomeren und Photoinitiatoren, dadurch gekennzeichnet, daß man hierbei durch Photopolymerisation vernetzbare Gemische verwendet, welche als Bindemittel Copolymerisate enthalten, die man aus
$a_1$) 30 bis 70 Gew.% Ethylen,
$a_2$) 5 bis 40 Gew.% (Meth)Acrylsäure und
$a_3$) 5 bis 50 Gew.% mindestens eines Vinylesters, Vinylethers, (Meth)Acrylsäureesters und/oder (Meth)Acrylsäureamids
hergestellt hat.

2. Verfahren nach Anspruch 1, dadurch gekennzeichnet, daß man die Copolymerisate aus
$a_1$) 40 bis 60 Gew.% Ethylen,
$a_2$) 8 bis 30 Gew.% (Meth)Acrylsäure und
$a_3$) 20 bis 40 Gew.% mindestens eines Vinylesters, Vinylethers, (Meth)Acrylsäureesters und/oder (Meth)Acrylsäureamids
hergestellt hat.

3. Verfahren nach einem der Ansprüche 1 oder 2, dadurch gekennzeichnet, daß die Copolymerisate als Baustein $a_3$ n-Butylacrylat, 2-Ethylacrylat und/oder ω-Methyl-poly(ethylenoxid)-α-yl-acrylat einpolymerisiert enthalten.

4. Verfahren nach einem der Ansprüche 1, 2 oder 3, dadurch gekennzeichnet, daß die Copolymerisate als Salze von Kationen von Metallen, mehrfach funktionellen Aminen und/oder von Hydrazin vorliegen.

**Claims for the Contracting States: CH, DE, ES, FR, GB, IT, LI, NL, SE**

1. A mixture crosslinkable by photopolymerization and based on binders, photopolymerizable monomers compatible therewith and photoinitiators, containing as binders copolymers prepared from $a_1$) from 30 to 70% by weight of ethylene, $a_2$) from 5 to 40% by weight of (meth)acrylic acid and $a_3$) from 5 to 50% by weight of at least one vinyl ester, vinyl ether, (meth)acrylic acid ester and/or (meth)acrylide.

2. A mixture as claimed in claim 1 which contains as binders copolymers prepared from $a_1$) from 40 to 60% by weight of ethylene, $a_2$) from 8 to 30% by weight of (meth)acrylic acid and $a_3$) from 20 to 40% by weight of at least one vinyl ester, vinyl ether, (meth)acrylic acid ester and/or (meth)acrylamide.

3. A mixture as claimed in claim 1 or 2, wherein the copolymers contain as unit $a_3$ n-butyl acrylate, 2-ethyl-hexyl acrylate and/or ω-methyl-poly(ethylene oxide)-α-yl acrylate as copolymerized units.

4. A mixture as claimed in any one of claims 1, 2 and 3, wherein the copolymers are present as salts of cations of metals, polyfunctional amines and/or hydrazine.

5. Use of a mixture as claimed in any one of claims 1, 2 and 3 for preparing photocrosslinkable printing plates, relief plates and photoresists.

6. Use of a mixture as claimed in any one of claims 1, 2 and 3 for preparing photocrosslinked printing forms, relief forms and photoresists.

7. A photocrosslinkable printing plate, relief plate or photoresist prepared using a mixture as claimed in any one of claims 1, 2 and 3.

8. A photocrosslinked printing plate, relief plate or photoresist prepared using a mixture as claimed in any one of claims 1, 2 and 3.

**Claims for the Contracting State: AT**

1. A process for producing a photocrosslinked printing plate, relief plate or photoresist by imagewise exposure and washout of the unexposed areas of a photocrosslinkable printing plate, relief plate or photoresist having a relief-forming layer (R5) formed from a mixture crosslinkable by photopolymerization and based on binders, photopolymerizable monomers compatible therewith and photoinitiators, containing as binders copolymers prepared from $a_1$) from 30 to 70% by weight of ethylene, $a_2$) from 5 to 40% by weight of (meth)acrylic acid and $a_3$) from 5 to 50% by weight of at least one vinyl ester, vinyl ether, (meth)acrylic acid ester and/or (meth)acrylamide.

2. A process as claimed in claim 1, wherein the copolymers have been prepared from $a_1$) from 40 to 60% by weight of ethylene, $a_2$) from 8 to 30% by weight of (meth)acrylic acid and $a_3$) from 20 to 40% by weight of at least one vinyl ester, vinyl ether, (meth)acrylic acid ester and/or (meth)acrylamide.

3. A process as claimed in either one of claims 1 or 2, wherein the copolymers contain as unit $a_3$ n-butyl acrylate, 2-ethylacrylate and/or ω-methyl-poly(ethylene oxide)-α-yl acrylate as copolymerized units.

4. A process as claimed in any one of claims 1, 2 and 3, wherein the copolymers are present as salts of cations of metals, polyfunctional amines and/or hydrazine.

**Revendications pour les Etats contractants: CH, DE, ES, FR, GB, IT, LI, NL, SE**

1. Mélanges réticulables par polymérisation, à base de liants, de monomères photopolymérisables compatibles avec eux et de photoimitateurs, caractérisé par le fait qu'ils contiennent, comme liants des copolymérisats, préparés à partir de
$a_1$) 30 à 70% en poids d'éthylène
$a_2$) 5 à 40% en poids d'acide (méth)acrylique et
$a_3$) 5 à 50% en poids d'au moins un ester acrylique et/ou amide d'acide (méth)acrylamide.

2. Mélanges selon la revendication 1, caractérisé par le fait qu'ils contiennent, comme liants, des copolymérisats préparés à partir de
$a_1$) 40 à 60% en poids d'éthylène
$a_2$) 8 à 30% en poids d'acide (méth)acrylique et
$a_3$) 20 à 40% en poids d'au moins un ester vinylique, éther vinylique, ester d'acide (méth)acrylique et/ou amide d'acide (méth)acrylamide.

3. Mélanges selon la revendication 1 ou 2, caractérisé par le fait que les copolymérisats contiennent en polymérisation, comme élément structurel $a_3$, de l'acrylate de n-butyle, de 2-éthylhexyle, et/ou de ω-méthylpoly(éthylénoxyd)-α-yle.

4. Mélanges selon l'une des revendications 1, 2 ou 3, caractérisé par le fait que les copolymérisats sont présents sous forme de cations de métaux, amines polyfonctionnelles et/ou d'hydrazine.

5. Utilisation des mélanges selon l'une des revendications 1, 2 ou 3 pour la fabrication de plaques d'impression photoréticulables, plaques à relief et photoréserves (photorésists).

6. Utilisation des mélanges selon l'une des revendications 1, 2 ou 3 pour la fabrication de formes d'impression, formes à relief et photoréserves (photorésists).

7. Plaques d'impression photoréticulables, plaques à relief et photoréserves (photorésists) préparées en utilisant des mélanges selon l'une des revendications 1, 2 ou 3.

8. Formes d'impression, formes à relief et photoréserves (photorésists) préparées en utilisant des mélanges selon l'une des revendications 1, 2 ou 3.

**Revendications pour l'Etat contractant: AT**

1. Procédé de fabrication de formes d'impression, formes à relief et photoréserves (photorésists) par exposition selon une image et lavage des portions de couche non exposées de plaques d'impression photoréticulables, plaques à relief et photoréserves (photorésists) à couches formant relief (R.S.) et par photopolymérisation de mélanges réticulables à base de liants, de monomères photopolymérisables compatibles avec eux et de photoimitateurs caractérisé par le fait qu'on utilise, comme mélanges réticulables par polymérisation, des mélanges qui contiennent, comme liants des copolymérisats, préparés à partir de

$a_1$) 30 à 70% en poids d'éthylène

$a_2$) 5 à 40% en poids d'acide (méth)acrylique et

$a_3$) 5 à 50% en poids d'au moins un ester vinylique, éther vinylique, ester d'acide (méth)acrylique et/ou amide d'acide (méth)acrylamide.

2. Procédé selon la revendication 1, caractérisé par le fait que l'on a préparé les copolymérisats à partir de

$a_1$) 40 à 60% en poids d'éthylène

$a_2$) 8 à 30% en poids d'acide (méth)acrylique et

$a_3$) 20 à 40% en poids d'au moins un ester vinylique, éther vinylique, ester d'acide (méth)acrylique et/ou amide d'acide (méth)acrylamide.

3. Procédé selon l'une des revendications 1 ou 2, caractérisé par le fait que les copolymérisats contiennent en polymérisation, comme élément structurel a3, de l'acrylate de n-butyle, de 2-éthylhexyle, et/ou de ω-méthyl-poly(éthylénoxyd)-α-yle.

4. Procédé selon l'une des revendications 1, 2 ou 3, caractérisé par le fait que les copolymérisats sont présents sous forme de cations de métaux, amines polyfonctionnelles et/ou d'hydrazine.